# EUROPEAN PATENT APPLICATION

(11) **EP 2 270 525 A1**
(43) Date of publication of application: **05.01.2011**
(21) Application number: 09305642.2
(22) Date of filing: 02.07.2009
(51) Int. Cl.: G01R 31/317, G11C 16/34

(54) **Method of auditing the wear of a memory embedded in a secure electronic token**

(71) Applicant: Gemalto SA, 92190 Meudon (FR)
(72) Inventor: Faure, Frédéric, 13260, CASSIS (FR); Charles, Yan, 13390, AURIOL (FR)

(57) **Abstract**

The invention is a method of auditing the wear of a non volatile memory embedded in a secure electronic token. The non volatile memory comprises a basic unit. The token is associated with a mission profile which is intended to reflect the use of the non volatile memory for a preset duration. The token comprises a first counter which is updated each time a data is written or erased in the basic unit. The token is intended to execute applicative commands. The token comprises a second counter. The method comprises the step of
a) updating the second counter each time an applicative command belonging to a preset set is executed,
b) sending the two counters to a distant machine,
c) comparing the two counters to the mission profile.

## Description

### (Field of the invention)

The present invention relates to methods of auditing the wear of a memory embedded in a secure electronic token. It relates particularly to methods of auditing the lifespan of a non volatile memory which is embedded in electronic tokens.

### (Prior art)

Electronic tokens are portable electronic devices with limited resources. In general, electronic tokens comprise a plurality of memories of different type. For example, they may comprise memory of RAM, ROM, EEPROM or Flash type. Smart cards, and particularly SIM cards, are secure electronic tokens.

There is a need for using secure electronic tokens in the Machine to Machine market, also named as M2M market. M2M market requires hardware/software components able to run in environment conditions covering a large scope and during a long time. Typically, these components may be able to comply with a temperature range from -40°C up to +125°C, a high level humidity. These components may also comply with a lifespan up to 15 years.

M2M market uses wireless modules which are integrated in systems for providing M2M communicating services. The wireless modules may comprise secure electronic tokens such as SIM cards. The SIM card chip lifespan depends mostly on two factors: the number of erase/write cycles and the data retention time. Silicon manufacturers generally guarantee these two factors for their chips in SIM card usual conditions, that is to say in the range of 20°C-25°C.

The number of erase/write cycles supported by a chip and the data retention highly depends on environmental conditions such as temperature.

In addition, the SIM card chip lifespan also depends on the usage of the SIM card. For example, when an application that stresses a specific part of the memory is often activated, the threshold of maximum number of erase/write cycles may be reached quickly. In particular, the stressed memory area may be a counter or a file frequently updated during an application processing.

It is known to implement long life mechanisms in SIM card to extend the lifespan of SIM memory. In particular, wear leveling and memory cell anti-aging mechanisms may be set in order to improve chip usage time. These mechanisms are initialized before or during the personalization stage of the SIM card.

In order to estimate the future lifespan of a secure token, a mission profile may be associated to a token. Such a mission profile is intended to reflect the future use of the non volatile memory of the token. Usually, the mission profile is built by estimating the number of applicative commands which are supposed to be executed by the token. Knowing the number of accesses to the non volatile memory for each kind of applicative commands it is then possible to compute an estimated lifespan for a token. For example the mission profile may be based on the assumption that three "authenticate" commands, two "select file" commands and four "update file" commands will be executed on a daily basis. The assessment may also be computed on a monthly or yearly basis. The assessment of the token memory lifespan is important since the token issuer may have to commit on a fixed memory lifespan. In particular, all issues related to the memory lifespan may be treated by a contractual guarantee.

However, at the time of the mission profile building, the pieces of information related to the behavior of the applications using the token may be incomplete or insufficient. Moreover, the pieces of information related to the behavior of the applications using the token may be erroneous or false.

As a consequence, there is a need to check that a mission profile is suitable for a secure token. In particular it is important to be able to check the suitability of a mission profile for a token even if the token has been issued and deployed on the field.

### (Summary of the Invention)

An object of the invention is to solve the above mentioned technical problem.

The object of the present invention is a method of auditing the wear of a non volatile memory which is embedded in a secure electronic token. The non volatile memory comprises a basic unit. The secure electronic token is associated with a mission profile which is intended to reflect the use of the non volatile memory for a preset duration. The secure electronic token comprises a first counter which is updated each time a data is written or erased in the basic unit. The secure electronic token is intended to execute applicative commands and comprises a second counter. The method comprises the following steps:
a) updating the second counter each time an applicative command belonging to a preset set is executed,
b) sending first and second counters to a distant machine,
c) comparing first and second counters to said mission profile.

In a preferred embodiment, the preset set may be stored in the secure electronic token and the mission profile is stored in the distant machine.

Advantageously, the applicative commands may be generated by an application comprising a software code and the method may comprise the step of checking the software code of the application if first and second counters are not consistent with the mission profile.

In a preferred embodiment, the method may comprise the further step of updating the mission profile if first and second counters are not consistent with said mission profile.

Advantageously, the method may comprise the further step of updating the preset set if first and second counters are not consistent with said mission profile.

In a preferred embodiment, the counter sending may be triggered when the first counter reaches a first preset threshold or when the second counter reaches a second preset threshold.

Advantageously, the secure electronic token may comprise SIM features and the sending of the first and second counters may be performed through a OTA session.

In a preferred embodiment, the secure electronic token may comprise a working memory. The first counter may be managed through a first part which is stored in the working memory and a second part that is stored in the non volatile memory. The first part may be saved in the second part when a preset event occurs.

Another object of the invention is a secure electronic token comprising a non volatile memory, a first counter and a second counter. The non volatile memory comprises a basic unit. The first counter is updated each time a data is written or erased in the basic unit. The secure electronic token is associated with a mission profile which is intended to reflect the use of the non volatile memory for a preset duration. The secure electronic token is intended to execute applicative commands. The secure electronic token comprises a preset set of applicative commands, a first means which is capable of updating the second counter each time an applicative command belonging to the preset set is executed. The secure electronic token comprises a second means which is capable of sending first and second counters to a distant machine.

Advantageously, the secure electronic token may comprise a third means which is capable of updating the preset set.

In a preferred embodiment, the secure electronic token may comprise first and second preset thresholds and a fourth means which is capable of triggering the counter sending when the first counter reaches the first preset threshold or when the second counter reaches the second preset threshold.

Advantageously, the secure electronic token may comprise a working memory. The first counter may be managed through a first part which is stored in the working memory and a second part which is stored in the non volatile memory. The first part may be saved in the second part when a preset event occurs.

In a preferred embodiment, the secure electronic token may be a SIM smart card.

Advantageously, the secure electronic token may be intended to be connected to a device which is capable of establishing a wireless channel for Machine To Machine purpose.

Another object of the invention is a device comprising a fifth means which is capable of establishing a wireless channel with a distant machine. The device comprises a communication interface and a secure electronic token having the above-described features. The secure electronic token is connected to the device by means of a welding or in a removable way.

Another object of the invention is a system, comprising a distant machine, a device and a secure electronic token. The secure electronic token complies with the above-described features and the device complies wit the above-described features. The distant machine comprises a sixth means which is capable of comparing first and second counters to the mission profile.

### (Brief description of the drawings)

Other characteristics and advantages of the present invention will emerge more clearly from a reading of the following description of a number of preferred embodiments of the invention with reference to the corresponding accompanying drawings in which:
- Figure 1 is an example of a system comprising a distant server, a wireless device and a secure electronic token according to the invention; and
- Figure 2 depicts schematically the architecture of a subscriber identity card of SIM smart card type according to the invention.

### (Detailed description of the preferred embodiments)

The invention may apply to any types of secure electronic token able to exchange data with a distant machine by means of a communication channel. In particular, the secure electronic token may be connected to a wireless device which provides means for establishing a communication channel between a distant machine and the secure electronic token. In this specification, the secure electronic token is a SIM card but it could be any other kind of secure electronic token comprising both a non volatile memory and means for exchanging data with a distant machine. For example the token may be a SIM card connected to a mobile phone or to a personal computer.

The invention relies on the simultaneous management of two types of counters which track the memory use at both applicative level and low level. The low level corresponds to the memory array level. Both counters are then analyzed versus the associated mission profile in order to check the compliance. Both applicative level counter and low level counters are supposed to increase according to close rules since the execution of each applicative command results into low level memory writing.

The invention is well suited for secure tokens intended to be used in the M2M domain.

An advantage of the invention is to allow building a mission profile for a set of tokens deployed on the field.

Another advantage of the invention is to allow building a mission profile for a set of tokens even if no mission profile has been previously defined for these tokens.

Another advantage of the invention is to allow determining the default root when an issue occurs on a token deployed on the field. In particular, the invention provides a way to check if the wear issue comes from the token itself or comes from the use of the token by the deployed applications.

Thanks to the invention, the field return analysis allows checking the conformity of a mission profile. Thus the business commitments may be accurately amended.

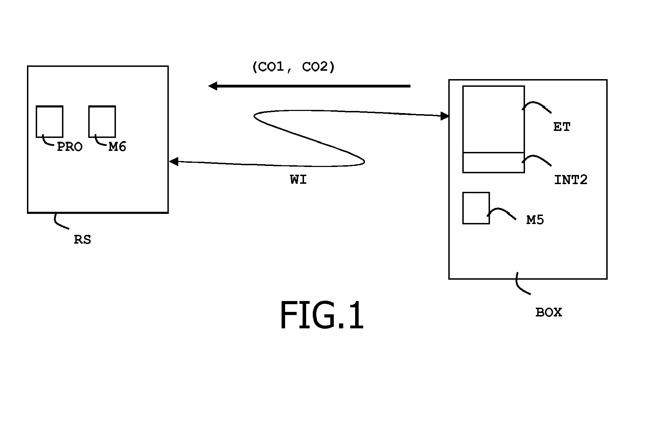

**Figure 1** shows an example of system comprising a distant machine RS, and a wireless device BOX having a secure electronic token ET according to the invention.

The distant machine RS may be a server able to exchange data by means of a wireless channel WI. The wireless channel WI may be the Over The Air mechanism - known as OTA - defined by the GSM 03.40, GSM 03.48 and/or ETSI/SCP - 3GPP - 3GPP2 standards. The wireless device BOX comprises a communication interface INT2, a secure electronic token ET connected to the interface INT2 and a means M5. The secure electronic token ET may be a SIM card. The means M5 is able to establish a wireless channel WI with the distant machine RS.

Alternatively, the distant machine RS may be a server able to exchange data by means of a network channel, in particular through the Internet.

The wireless device BOX may comprise a secure electronic token ET of SIM smart card type. The wireless device BOX may be integrated in systems such as an automatic drink distributor or a car for example.

The distant machine RS comprise a mission profile PRO and a means M6. The distant machine RS is intended to establish a communication channel with the token ET and to get counters value from the token ET. The mission profile PRO is associated to the token ET. The means M6 is capable of comparing the counter values retrieved from the token ET to the mission profile PRO. Advantageously, the means M6 may be able to create a new mission profile from counter values retrieved from the token ET.

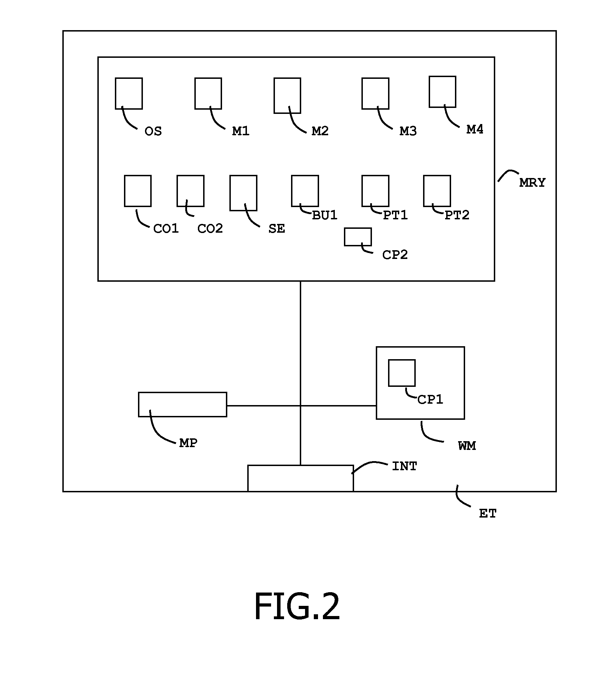

**Figure 2** shows an example of architecture of a SIM card as an example of a subscriber identity card according to a preferred embodiment of the invention. The SIM card ET contains a microprocessor MP, a communication interface INT, a non volatile memory MRY, and a working memory WM. The working memory may be a RAM. The communication interface INT is intended to be connected to a wireless device and allows exchanging data with the connected device. The memory MRY may be an EEPROM or a Flash memory. The memory MRY contains an operating system OS, two counters CO1 and CO2, two thresholds PT1 and PT2, a preset set of applicative commands SE, and four means M1, M2, M3 and M4. In the example of Figure 2, the memory MRY is implemented as a unique non volatile memory. The memory MRY may also be implemented as any combination of several non volatile memories of different types.

In general the memory MRY comprises a series of basic memory units. In a preferred embodiment, each basic memory unit is the minimum memory area allowing an atomic write or erase operation. A first basic unit BU1 is drawn on Figure 2. In this specification the counter CO1 is associated to the basic unit BU1. In other words, the counter CO1 contains a representative value of the number of write and erase operations performed in the basic unit BU1. The counter CO1 may contain the right and accurate number of write and erase operations performed in the basic unit BU1. Alternatively, the counter CO1 may contain a value close to the right number of write and erase operations performed in the basic unit BU1. Thus the counter CO1 may contain an estimated value of the right write and erase operations.

The means M1 is able to update the second counter CO2 each time an applicative command belonging to the preset set SE is executed in the secure token ET.

The means M2 is able to send the two counters CO1 and CO2 to a distant machine RS.

The means M3 is able to update the preset set SE of applicative commands.

The means M4 is able to trig the counter sending when the first counter CO1 reaches the preset threshold PT1 or when the second counter CO2 reaches the preset threshold PT2.

In a preferred embodiment, the counter CO1 is managed through two associated parts CP1 and CP2. The first part CP1 is stored in the working memory WM. The second part CP2 is stored in the non volatile memory MRY. Each time a write and/or erase operation is carried out for the basic unit BU1, the first part CP1 is incremented. Then the first part CP1 is copied into the second part CP2 when a preset event occurs. For example, the event may be a preset date/time. Alternatively the modification of CP2 may be triggered when the value stored in CP1 reaches a preset value. For example, incrementing CP2 may be performed when the value of CP1 modulo 10, 100 or 1000 is equal to 0. The preset event may be selected by a person skilled in the domain of memory stress and depending on the application requirement in order to reduce the risk of loss of counter value in case of power loss.

Thanks to this embodiment, the non volatile memory wear is reduced since the majority of counter updating is done in the working memory.

The counter CO2 may be managed in a similar way in order to reduce the stress of the memory MRY.

The operating system OS may comprise a virtual machine, in particular a Java ® virtual machine or a .Net ® virtual machine.

The microprocessor MP cooperates with the working memory WM and is intended to run the operating system OS. The four means M1 to M4 may be either software applications run by the microprocessor MP or hardware designed. The four means may be implemented as four distinct elements or merged in one or several elements.

In a preferred embodiment, the four means are implemented as four different software components.

According to the invention, an example of embodiment of the method of auditing the wear of the memory MRYcomprises several steps.

First the mission profile is built according to the planned future usage of the secure token. In particular, an off line characterization of the OS is run in order to estimate the wearing of each applicative command. For example, such a characterization can be run on all possible applicative commands that can be executed in the token. For a smart card, the APDU commands corresponding to every applicative command are sent to the token and a deep analysis of the non volatile memory is performed in order to get the relevant ratios. Such an analysis may be carried out thanks to an emulator or a simulator.

Then the counter CO1 is updated each time a data is written or erased in the basic unit BU1. In parallel, the second counter CO2 is updated each time an applicative command belonging to the preset set SE is executed in the token ET.

Then the distant server SR requests the sending of the counters values. In response, the secure token ET sends the two counters CO1 and CO2 to the distant server RS.

Alternatively the counter sending may be token-initiated.

The server RS is supposed to know the full duration of use for the token ET. Then the server RS compares the two received counters CO1 and CO2 to the mission profile PRO which is associated to the token ET. The checking is based on the duration of use for the token ET. For example the duration may be one month. In order to correctly compare the counters values to the mission profile, the server may keep an historic of the received values for the two counters CO1 and CO2.

Alternatively, the historic of the counters value may be stored in the token. In such a case, the token send the full historic to the server in addition to the current value of the counters.

Ideally, since an offline OS characterization has been run, only the counter CO2 can be used to calculate the token's memory wearing. However, the applicative environment of the token is not fully controlled: some application may run in it and may perform memory updating that can anticipate token death.

Such applicative stressing can therefore be identified while comparing the counter CO1 against the expected low level wearing regarding the counter CO2.

Advantageously, the token ET may send its own identifier with the two counter CO1 and CO2. This identifier allows the server to match the relevant mission profile with the token.

In a preferred embodiment, the memory MRY may comprise a plurality of basic units. The token may manage as many low level counters as basic units. Thus the token may send the plurality of low level counters which are associated to basic units. The token may manage as many applicative level counters as required. Thus the token may send the plurality of applicative level counters.

When the server RS detects that the received counter values are not consistent with the relevant mission profile, a deep checking of the software code of the application is started. This analysis is carried out for the applications which use the token features.

If the counter analysis concludes that the mission profile is unsuitable, the mission profile may be updated thanks to the data retrieved from the token. In particular, when the counter CO2 has a value greater than the expected value, it provides assign of undervaluation of the real number of executed applicative commands.

In order to get additional information, the server RS may request an update of the set SE in the token ET. For example, the new applicative commands may be added to the set SE. Thus the next sending of counter values to the servers will take into account the additional tracked commands.

The sending of the counter values may be performed when the counter reaches predefined thresholds PT1 and PT2. For example, the counters may be sent when the counter CO1 modulo 100, 500, 1000 or 5000 is equal to 0.

Advantageously, the threshold value may depend on the basic unit type. For example all basic units belonging to the memory area comprised in the range [0x0000 - 0X4000] may be associated to a dedicated threshold and all basic units belonging to the memory area comprised in the range [0x4001 - 0X8000] may be associated to a another threshold.

Advantageously, the server RS may conclude that the memory MRY is near its end of life if a token counter reaches a preset alert value. Alternatively, the token itself may conclude that the memory MRY is near its end of life if a token counter reaches a preset alert value. In such a case the token may send an alert message to the server RS. In both cases, the server RS may notify the M2M customer that the secure token ET shall be replaced. The invention provides a way to know the wearing state of a secure token on the field.

Advantageously, the server RS may communicate with the token ET through OTA or through the Internet either in push or pull mode. The server may use SMS, GPRS through BIP, or any other wireless or wired protocols.

Thanks to the invention, the server may launch a deep analysis of the applications which use the secure token even if a non predictable combination of applicative commands is regularly sent to the token. Generally, the application which use the secure token are stored in a machine connected to the token. This connected machine may be a wireless device BOX, a mobile phone or any computer able to exchange command/responses with the token.

Alternatively, another embodiment of the method may start without building any mission profile for the token ET. In this case, the server generates a mission profile according to the counters value received from the token.

## Claims

1. A **method** of auditing the wear of a non volatile memory (MRY) embedded in a secure electronic token (ET), the non volatile memory (MRY) comprising a basic unit (BU1), said secure electronic token (ET) being associated with a mission profile (PRO) intended to reflect the use of the non volatile memory (MRY) for a preset duration, said secure electronic token (ET) comprising a first counter (CO1) which is updated each time a data is written or erased in said basic unit (BU1), said secure electronic token (ET) being intended to execute applicative commands,
**characterized in that** said secure electronic token (ET) comprises a second counter (CO2) and **in that** said method comprises the following steps:
a) updating the second counter (CO2) each time an applicative command belonging to a preset set (SE) is executed,
b) sending first and second counters (CO1, CO2) to a distant machine (RS),
c) comparing first and second counters (CO1, CO2) to said mission profile (PRO).

2. A method according to claim 1, wherein applicative commands are generated by an application comprising a software code and wherein said method comprises the further step of:
d) checking the software code of the application if first and second counters (CO1, CO2) are not consistent with said mission profile (PRO).

3. A method according to claim 1, wherein said method comprises the further step of:
e) updating the mission profile (PRO) if first and second counters (CO1, CO2) are not consistent with said mission profile (PRO).

4. A method according to claim 1, wherein said method comprises the further step of:
f) updating said preset set (SE) if first and second counters (CO1, CO2) are not consistent with said mission profile (PRO).

5. A method according to one of claims 1 to 4, wherein the counter sending is triggered when said first counter reaches a first preset threshold (PT1) or said second counter reaches a second preset threshold (PT2).

6. A method according to one of claims 1 to 5, wherein said secure electronic token (ET) comprises SIM features and wherein the sending of said first and second counters (CO1, CO2) is carried out through a OTA session.

7. A method according to one of claims 1 to 6, wherein the secure electronic token (ET) comprises a working memory (WM) and wherein the first counter is managed through a first part (CP1) stored in the working memory (WM) and a second part (CP2) stored in the non volatile memory (MRY), said first part (CP1) being saved in said second part (CP2) when a preset event occurs.

8. A **secure electronic token** (ET) comprising a non volatile memory (MRY) and a first counter (CO1), the non volatile memory (MRY) comprising a basic unit (BU1), the first counter (CO1) being updated each time a data is written or erased in said basic unit (BU1), said secure electronic token (ET) being associated with a mission profile (PRO) intended to reflect the use of the non volatile memory (MRY) for a preset duration, said secure electronic token (ET) being intended to execute applicative commands,
**characterized in that** said secure electronic token (ET) comprises :
- a second counter (CO2),
- a preset set (SE) of applicative commands,
- a first means (M1) able to update the second counter (CO2) each time an applicative command belonging to the preset set (SE) is executed,
- a second means (M2) able to send first and second counters (CO1, CO2) to a distant machine (RS).

9. A secure electronic token (ET) according to claim 8, wherein said secure electronic token (ET) comprises a third means (M3) able to update said preset set (SE).

10. A secure electronic token (ET) according to claim 8 or 9, wherein said secure electronic token (ET) comprises first and second preset thresholds (PT1, PT2) and wherein said secure electronic token (ET) comprises a fourth means (M4) able to trigger the counter sending when said first counter (CO1) reaches the first preset threshold (PT1) or when said second counter (CO2) reaches the second preset threshold (PT2).

11. A secure electronic token (ET) according to one of claims 8 to 10, wherein said secure electronic token (ET) comprises a working memory (WM) and wherein the first counter (CO1) is managed through a first part (CP1) stored in the working memory (WM) and a second part (CP2) stored in the non volatile memory (MRY), said first part (CP1) being saved in said second part (CP2) when a preset event occurs.

12. A secure electronic token (ET) according to one of claims 8 to 11, wherein said secure electronic token (ET) is a SIM smart card.

13. A secure electronic token (ET) according to one of claims 8 to 12, wherein said secure electronic token (ET) is intended to be connected to a device (BOX) able to establish a wireless channel (WI) for M2M purpose.

14. A **device** (BOX), comprising:
- a fifth means (M5) able to establish a wireless channel (WI) with a distant machine (RS),
- a secure electronic token (ET),
- a communication interface (INT2),
**characterized in that** said secure electronic token (ET) is according to claim 8 and **in that** said secure electronic token (ET) is connected to said device (BOX) by means of a welding or in a removable way.

15. A **system,** comprising:
- a distant machine (RS),
- a device (BOX),
- a secure electronic token (ET),
**characterized in that** said secure electronic token (ET) is according to claim 8, said device (BOX) is according to claim 14, and **in that** said distant machine (RS) comprises a sixth means (M6) able to compare first and second counters (CO1, CO2) to the mission profile (PRO).
